# EUROPÄISCHE PATENTANMELDUNG

(11) **EP 3 252 485 A1**
(43) Veröffentlichungstag der Anmeldung: **06.12.2017**
(21) Anmeldenummer: 17173933.7
(22) Anmeldetag: 01.06.2017
(51) Int. Cl.: G01R 31/14, G01R 31/12, G01R 31/02

(54) **HOCHSPANNUNGSSCHALTUNGSANORDNUNG ZUR DIAGNOSE UND PRÜFUNG VON BETRIEBSMITTELN DER ELEKTRISCHEN ENERGIETECHNIK**

(30) Priorität: 02.06.2016 DE 102016209700
(71) Anmelder: Hagenuk KMT Kabelmesstechnik GmbH, 01471 Radeburg (DE)
(72) Erfinder: Scheuschner, Sven, 01471 Radeburg (DE); Brunner, Falk, 01129 Dresden (DE); Stechemesser, Nico, 01067 Dresden (DE)
(74) Vertreter: Kailuweit & Uhlemann Patentanwälte Partnerschaft mbB

(57) **Zusammenfassung**

Die Erfindung betrifft Hochspannungsschaltungsanordnungen zur Diagnose und Prüfung von Betriebsmitteln der elektrischen Energietechnik mit
- wenigstens einer ein Bezugspotential und ein Spannungspotential aufweisenden Hochspannungsquelle,
- einer mit dem Spannungspotential der Hochspannungsquelle verbundenen Schalteinrichtung in Verbindung mit einer Reihenschaltung aus einem Schutzwiderstand und einer Umschwingdrossel,
- dem mit der Umschwingdrossel und dem Bezugspotential zusammengeschalteten Betriebsmittel und
- einer Umschwingschalteranordnung zwischen der Verbindung des Schutzwiderstands mit der Umschwingdrossel und dem Bezugspotential.

Die Hochspannungsschaltungsanordnungen zeichnen sich insbesondere durch eine einfache Schaltungsanordnung zum Schalten der relativ hohen Umschwingströme aus. Dazu besteht die Umschwingschalteranordnung aus einer in Reihe geschalteten Kaskade von Hochspannungsschaltsegmenten. Das Hochspannungsschaltsegment weist zur Kommutierung zwei Brückenzweige mit Dioden zur Nennstromübernahme und wenigstens einen Bipolartransistor mit isolierter Gate-Elektrode (IGBT - insulated-gate bipolar transistor) zur Nennstromübernahme auf. Weiterhin sind die Gate-Elektroden der Bipolartransistoren mit einer Gate-Ansteuerung verbunden.

## Beschreibung

Die Erfindung betrifft Hochspannungsschaltungsanordnungen zur Diagnose und Prüfung von Betriebsmitteln der elektrischen Energietechnik mit
- wenigstens einer ein Bezugspotential und ein Spannungspotential aufweisenden Hochspannungsquelle,
- einer mit dem Spannungspotential der Hochspannungsquelle verbundenen Schalteinrichtung in Verbindung mit einer Reihenschaltung aus einem Schutzwiderstand und einer Umschwingdrossel,
- dem mit der Umschwingdrossel und dem Bezugspotential zusammengeschalteten Betriebsmittel und
- einer Umschwingschalteranordnung zwischen der Verbindung des Schutzwiderstands mit der Umschwingdrossel und dem Bezugspotential.

Hochspannungsschaltungsanordnungen zur Diagnose und Prüfung von Betriebsmitteln der elektrischen Energietechnik können insbesondere zur Kabelfehlerortung eingesetzt werden. Dabei wird dem Kabel als Betriebmittel der elektrischen Energietechik ein Spannungsimpuls zugeführt und die reflektierten Spannungen als Teilentladungen erfasst und dem Kabelende und eventuellen Fehlern im Kabel zugeordnet.

Hochspannungsschaltungsanordnungen zur Diagnose und Prüfung werden für die Inbetriebnahme und turnusmäßige Zustandsbeurteilung von Betriebsmitteln der elektrischen Energietechnik verwendet. Dabei werden diese insbesondere zur
a) Spannungsprüfung des Betriebsmittels, wobei das Ergebnis ein 0- oder 1-Resultat ist, dass bedeutet entweder das Betriebsmittel besteht die Prüfung oder es kommt zu einer irreversiblen Zerstörung, beipsielsweise einem Durchschlag (Versagen) der Isolierung,
b) Zustandsbeurteilung (Diagnose) beispielsweise durch eine Teilentladungsmessung (TE-Messung) oder eine Messung des Verlustfaktors (tan delta) unter Hochspannungsbelastung, wobei eine irreversible Schädigung des Prüflings ausgeschlossen ist, und
c) Spannungsprüfung mit gleichzeitiger Diagnose eingesetzt. Der Unterschied zwischen b) und c) liegt in der Höhe der angelegten Spannung mit U_{c} > U_{b} und der Beanspruchungsdauer. Hier gilt meistens t_{c} > t_{b}.

Durch die Druckschrift DE 195 13 441 A1 ist ein Verfahren zur Prüfung der Isolation elektrischer Betriebsmittel sowie eine Schaltungsanordnung zur Ausführung des Verfahrens bekannt. Eine derartige Schaltungsanordnung kann zur Verlustfaktormessung benutzt werden. Aus den Phasenlagen der Prüfspannung und des daraus induzierten Prüfstroms wird der Verlustfaktor (tan Delta) des Prüflings bestimmt. Der Verlustfaktor ist ein Maß für den Verlust der elektrisch oder elektromagnetisch verlorengehenden Energie und damit ein Merkmal der elektrischen Eigenschaften des Prüflings. Die Erzeugung der Wechselspannung zur Prüfung erfolgt in mehreren Schritten aus einer Netzspannung. Aus der Netzspannung wird mit Hilfe eines Gleichrichters eine Gleichspannung erzeugt. Diese wird in Wechselspannungen mit Netzfrequenz oder einem Vielfachen der Netzfrequenz umgewandelt, welche mit Wechselspannungen niederer Frequenz in ihrer Amplitude moduliert sind. Durch Transformation der Niederspannungen mittels Hochspannungstransformatoren wird eine mit sehr niederer Frequenz amplitudenmodulierte Hochspannung erzeugt, mit welcher ein Prüfling über eine Gleichrichterschaltung definiert aufgeladen wird und danach eine definierte Entladung des Prüflings über einen Hochspannungsschalter erfolgt. Dieser besteht aus in Reihe geschalteten Halbleiterschaltern, die zu einer treppenförmigen Entladekurve führen.

Die Druckschrift DE 10 2012 024 560 B3 beinhaltet eine Schaltungsanordnung und ein Verfahren zur Erzeugung einer Prüfspannung und ein Prüfgerät zur Ermittlung eines Verlustfaktors, welches die Schaltungsanordnung enthält. Die Schaltungsanordnung besteht im Wesentlichen aus zwei Hochspannungsquellen zur Erzeugung einer positiven und einer negativen Hochspannung variabler Amplitude und eine zwischen den Ausgängen der Hochspannungsquellen und dem Prüfling angeordneten Hochspannungsschalteranordnung zur sukzessiven Auf- und Entladung des Prüflings. Mittels einer Regelung wird die aktuelle Prüfspannung am Prüfling gemessen und in Abhängigkeit davon wirkt diese zur definierten Auf- und Entladung des Prüflings auf die Hochspannungsschalteranordnung ein. Die Regelung wirkt nicht auf die Hochspannungsquellen ein. Ein Schalten der Hochspannung ist nicht vorgesehen.

Die Druckschrift DE 10 2011 117 491 A1 offenbart eine Prüfvorrichtung von Kabeln zur Spannungsprüfung durch eine VLF-Spannung zur Generierung einer kosinusrechteckförmigen Prüfspannung, wobei eine Gleichspannungsquelle das Kabel auf eine Spannung auflädt und das geladene Kabel über steuerbare Schaltelemente auf eine Gegenpolarität umschwingt sowie in einer weiteren Schaltstellung das Kabel auf die ursprüngliche Polarität zurückschwingt. Ein Umschalten der Polarität erfolgt über als Schalter ausgebildete Schaltelemente.

Die Druckschrift DE 103 33 241 B3 zeigt ein Prüfgerät zur Spannungsprüfung von Kabeln und Kabelgarnituren mit VLF-Spannung. Die dabei eingesetzte Hochspannungsschalteinrichtung weist Schaltkontakte auf.

Der im Patentanspruch 1 angegebenen Erfindung liegt die Aufgabe zugrunde, die hohen Umschwingströme einer Hochspannungsschaltungsanordnung zur Diagnose und Prüfung von Betriebsmitteln der elektrischen Energietechnik einfach zu schalten.

Diese Aufgabe wird mit den im Patentanspruch 1 aufgeführten Merkmalen gelöst.

Die Hochspannungsschaltungsanordnungen zur Diagnose und Prüfung von Betriebsmitteln der elektrischen Energietechnik mit
- wenigstens einer ein Bezugspotential und ein Spannungspotential aufweisenden Hochspannungsquelle,
- einer mit dem Spannungspotential der Hochspannungsquelle verbundenen Schalteinrichtung in Verbindung mit einer Reihenschaltung aus einem Schutzwiderstand und einer Umschwingdrossel,
- dem mit der Umschwingdrossel und dem Bezugspotential zusammengeschalteten Betriebsmittel und
- einer Umschwingschalteranordnung zwischen der Verbindung des Schutzwiderstands mit der Umschwingdrossel und dem Bezugspotential zeichnen sich insbesondere durch eine einfache Schaltungsanordnung zum Schalten der relativ hohen Umschwingströme aus.
Dazu besteht die Umschwingschalteranordnung aus einer in Reihe geschalteten Kaskade von Hochspannungsschaltsegmenten. Das Hochspannungsschaltsegment weist zur Kommutierung zwei Brückenzweige mit Dioden zur Nennstromübernahme und wenigstens einen Bipolartransistor mit isolierter Gate-Elektrode (IGBT - insulated-gate bipolar transistor) zur Nennstromübernahme auf. Weiterhin sind die Gate-Elektroden der Bipolartransistoren mit einer Gate-Ansteuerung verbunden.

Vorteilhafte Ausgestaltungen der Erfindung sind in den Patentansprüchen 2 bis 13 angegeben.

Die Brückenzweige des Hochspannungssegments bestehen nach der Weiterbildung des Patentanspruchs 2 aus jeweils zwei in Reihe geschalteter Dioden zur Nennstromübernahme, wobei in einem ersten Brückenzweig die Katoden der Dioden und im anderen zweiten Brückenzweig die Anoden der Dioden miteinander verbunden sind. Weiterhin sind die zusammengeschalteten Katoden der Dioden des ersten Brückenzweigs mit dem Kollektor des Bipolartransistors und die zusammengeschalteten Anoden der Dioden des zweiten Brückenzweigs mit dem Emitter des Bipolartransisitors verbunden. Darüber hinaus sind die zusammengeschalteten Brückenzweige und die Gate-Elektrode des Bipolartransistors die Anschlüsse des Hochspannungssegments.

Die Brückenzweige des Hochspannungssegments bestehen nach der Weiterbildung des Patentanspruchs 3 aus jeweils einer Reihenschaltung eines Bipolartransistors und einer Diode jeweils zur Nennstromübernahme, wobei in den Brückenzweigen jeweils der Emitter des Bipolartransistors mit der Anode der Diode zusammengeschaltet sind. Die Emitter der Bipolartransistoren und die Anoden der Dioden sind miteinander verbunden. Weiterhin sind die zusammengeschalteten Brückenzweige und die Gate-Elektroden oder der zusammengeschalteten Gate-Elektroden der Bipolartransistoren die Anschlüsse des Hochspannungssegments.

Parallel zu den Bipolartransistoren sind nach der Weiterbildung des Patentanspruchs 4 jeweils ein Feldeffekttransistor geschalten, wobei jeweils der Emitter des Bipolartransistors mit der Source-Elektrode des Feldeffekttransistors und der Kollektor des Bipolartransistors mit der Drain-Elektrode des Feldeffekttransistors verbunden sind. Die zusammengeschalteten Brückenzweige sind die Anschlüsse des Hochspannungsschaltsegments zur Kaskadierung. Die Gate-Elektroden der Bipolartransistoren und der Feldeffekttransistoren sind mit der Gate-Ansteuerung verbunden. Als Feldeffekttransistoren werden insbesondere MOSFET's (Metall-Oxid-Halbleiter-Feldeffekttransistor) verwendet.

Störungen in einer DAC-Anlage (DAC - gedämpfte Wechselspannung) sind nicht auszuschließen, wobei ein daraus folgendes Ausblenden von Signalen (Gating) zu einem Verlust an Informationen der zu messenden Teilentladungssignale führt. Ein Hauptstörer ist dabei der Schalter der DAC-Anlage, wobei dessen Störungen immer im Stromnulldurchgang und damit im Spannungsmaximum auftreten. Damit kann bei maximaler Spannung das Teilentladungsverhalten des des zu prüfenden Betriebsmittels nicht beurteilt werden. Vorteilhafterweise werden die von den Bipolartransistoren als Schalter erzeugten Störungen durch die Feldeffekttransistoren eliminiert. Eine Beurteilung des Teilentladungsverhaltens des zu prüfenden Betriebsmittels ist somit ohne Verlust an Teilentladungsinformationen möglich.

Durch die Parallelschaltung der Feldeffekttransistoren zu den Bipolartransistoren erfolgt eine Linearisierung der Bipolartransisitor- und der Dioden-Kennlinie im Stromnulldurchgang. Der Einschaltwiderstand der Feldeffekttransistoren ist bei kleinen Strömen und damit kleinen thermischen Veränderungen nahezu konstant. Die Feldeffekttransistoren tragen weiterhin auf Grund der größeren Einschaltwiderstände nur die kleinen Ströme. Ein weiterer Vorteil besteht darin, dass die Feldeffekttransistoren den Strom in beide Richtungen leiten können. Die große Stromlast wird von den Bipolartransistoren oder den Dioden getragen. Die Ansteuerung der Feldeffekttransistoren erfolgt mit der der Bipolartransistoren.

Zum Kollektor und zum Emitter des Bipolartransisitors ist nach der Weiterbildung des Patentanspruchs 5 eine antiparallel geschaltete Diode vorhanden.

Nach der Weiterbildung des Patentanspruchs 6 ist eine Schutzschaltung des Bipolartransistors mit dem Kollektor und dem Emitter des Bipolartransistors verbunden. Die Schutzschaltung kann dazu vorteilhafterweise aus einer Parallelschaltung einer Suppressordiode und/oder eines Varistors bestehen.

Zur Erhöhung des Nennstroms sind nach der Weiterbildung des Patentanspruchs 7 die Kollektoren und die Emitter von wenigstens zwei Bipolartransistoren verbunden.

Die Gate-Ansteuerung weist nach der Weiterbildung des Patentanspruchs 8 wenigstens einen Empfänger für elektromagnetische Strahlung in Verbindung mit den Gates der Bipolartransistoren, den Gates von Bipolartransistoren oder jeweils einem Gate eines Bipolartransisitors auf. Weiterhin ist der Empfänger oder sind die Empfänger für elektromagnetische Strahlung mit einem das Einschaltsignal oder das Ausschaltsignal erzeugenden Sender für elektromagnetische Strahlung verbunden.

Die Gate-Ansteuerung sind nach der Weiterbildung des Patentanspruchs 9 Treiber in Verbindung mit jeweils einem Gate des Bipolartransisitors. Jeder der Treiber ist mit einer mehrere Windungen aufweisenden Spule als Sekundärseite eines Ringkernübertragers verbunden. Die Primärseite des Ringkernübertragers ist eine Windung einer hochisolierenden Leitung.

In Fortführung kann die hochisolierende Leitung nach der Weiterbildung des Patentanspruchs 10 der Kern der Spulen als Primärseite des Ringkernübertragers sein.

Die Hochspannungsschaltungsanordnung ist nach der Weiterbildung des Patentanspruchs 11 eine Hochspannungsschaltungsanordnung zur Prüfung und Diagnose eines Kabels als Betriebsmittel, wobei die Schalteinrichtung zur Prüfung und Diagnose eine Verbindung zwischen Hochspannungsquelle und Schutzwiderstand herstellt und trennt. Damit bildet sich eine gedämpfte Wechselspannung (DAC-Spannung - Damped AC) durch die Umschwingschalteranordnung, die Umschwingdrossel und das Kabel aus.

Die Hochspannungsschaltungsanordnung ist nach der Weiterbildung des Patentanspruchs 12 eine Hochspannungsschaltungsanordnung zur Prüfung und Diagnose eines Betriebsmittels mit einer VLF (very low frequency) cosinusförmigen Spannung als eine Halbschwingung, wobei nach einem verbindenden und trennenden Schaltvorgang der Schalteinrichtung eine Aufladung des Betriebsmittels erfolgt, die cosinusförmige Halbschwingung durch die Umschwingschalteranordnung in Verbindung mit der Umschwingdrossel und dem Betriebsmittel generiert wird und durch einen Schaltvorgang eine Nachladung des Betriebsmittels erfolgt.

Die Hochspannungsschaltungsanordnung weist nach der Weiterbildung des Patentanspruchs 13 eine erste Hochspannungsquelle mit einer gegenüber dem Bezugspotential negativen Spannung an deren Ausgang und eine zweite Hochspannungsquelle mit einer gegenüber dem Bezugspotential positiven Spannung an deren Ausgang auf. Weiterhin sind die Ausgänge über eine Schalteinrichtung mit dem Schutzwiderstand verbunden, so dass am Schutzwiderstand gegenüber dem Bezugspotential die negative oder die positive Spannung der jeweiligen Hochspannungsquelle anliegt und zur Prüfung und Diagnose eines Betriebsmittels eine VLF (very low frequency) cosinusförmige Wechselspannung erzeugt wird.

Ein Ausführungsbeispiel der Erfindung ist in den Zeichnungen jeweils prinzipiell dargestellt und wird im Folgenden näher beschrieben.

Es zeigen:
- Fig. 1: eine Hochspannungsschaltungsanordnung,
- Fig. 2: ein kaskadierbares Hochspannungsschaltsegment mit Dioden und wenigstens einem Bipolartransistor mit isolierter Gate-Elektrode zur Nennstromübernahme,
- Fig. 3: ein kaskadierbares Hochspannungsschaltsegment mit Dioden und Bipolartransistoren mit isolierter Gate-Elektrode zur Nennstromübernahme,
- Fig. 4: ein kaskadierbares Hochspannungsschaltsegment mit Dioden, Bipolartransisitoren mit isolierter Gate-Elektrode und Feldeffekttransistoren,
- Fig. 5: eine Reihenschaltung von Hochspannungsschaltsegmenten,
- Fig. 6: ein mittels eines Hochspannungsschaltsegments hervorgerufener gedämpfter Laststromfluss,
- Fig. 7: ein mittels eines Hochspannungsschaltsegments im VLF-Betrieb hervorgerufenen Laststromfluss,
- Fig. 8: ein Blockschaltbild mit einer Gate-Ansteuerung mittels elektromagnetischer Strahlung,
- Fig. 9: eine Gate-Ansteuerschaltung mit einem Ringkernübertrager und
- Fig. 10: eine Gate-Ansteuerschaltung mit einem Impulsübertrager.

Eine Hochspannungsschaltungsanordnung zur Diagnose und Prüfung von Betriebsmitteln der elektrischen Energietechnik besteht im Wesentlichen aus wenigstens einer Hochspannungsquelle 1, einer Schalteinrichtung 2 einer Reihenschaltung aus einem Schutzwiderstand R und einer Umschwingdrossel L, dem Betriebsmittel und einer Umschwingschalteranordnung 3.

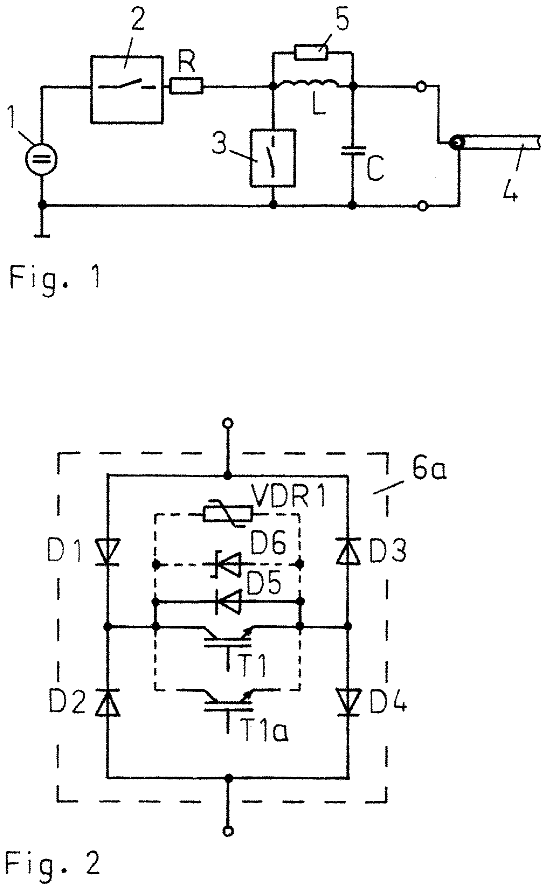

Die Fig. 1 zeigt eine Hochspannungsschaltungsanordnung in einer prinzipiellen Darstellung.

Die Hochspannungsschaltungsanordnung weist eine ein Spannungspotential gegenüber einem Bezugspotential bereitstellende Hochspannungsquellen 1 auf, die über die Schalteinrichtung 2 mit dem Schutzwiderstand R verbunden sind. Dem Schutzwiderstand R ist der Reihenschwingkreis bestehend aus der Umschwingdrossel L und dem Betriebsmittel als Kabel 4 nachgeschaltet. Weiterhin ist zwischen der Verbindung Schutzwiderstand R und Reihenschwingkreis und dem Potential die Umschwingschalteranordnung 3 geschalten. Parallel zur Umschwingdrossel L befindet sich ein Schutzglied 5. Zur Generierung einer gedämpften Wechselspannung (DAC-Spannung - Damped AC) kann auch auf das Schutzglied 5 verzichtet werden. Zwischen der Verbindung Umschwingdrossel L und Kabel 4 und Potential ist ein Stützkondensator C geschalten. Bei genügend großer Kapazitäts des Kabels 4 kann auf den Stützkondensator C auch verzichtet werden. Die Umschwingschalteranordnung 3 besteht aus einer Reihenschaltung von Hochspannungssegmenten 6.

Dabei können auch zwei Spannungspotentiale als negatives und als positives Spannungspotential nacheinander über die Schalteinrichtung 2 an den Schutzwiderstand R geschalten werden. Am Kabel 4 kann damit über die Umschwingdrossel L ein negatives und ein positives Spannungspotential zur Spannungsaufladung geschalten werden.

Die Fig. 2 zeigt ein kaskadierbares Hochspannungsschaltsegment 6a mit Dioden D und wenigstens einem Bipolartransistor T mit isolierter Gate-Elektrode zur Nennstromübernahme in einer prinzipiellen Darstellung.

In einer ersten Ausführungsform bestehen die Brückenzweige eines ersten Hochspannungssegments 6a aus jeweils zwei in Reihe geschalteten Dioden D1, D2, D3, D4 zur Nennstromübernahme, wobei in einem ersten Brückenzweig die Katoden der Dioden D1, D2 und im anderen zweiten Brückenzweig die Anoden der Dioden D3, D4 miteinander verbunden sind. Weiterhin sind die zusammengeschalteten Katoden der Dioden D1, D2 des ersten Brückenzweigs mit dem Kollektor des Bipolartransistors T1 und die zusammengeschalteten Anoden der Dioden D3, D4 des zweiten Brückenzweigs mit dem Emitter des Bipolartransisitors T1 verbunden. Die zusammengeschalteten Brückenzweige und das Gate des Bipolartransistors T1 sind die Anschlüsse des ersten Hochspannungssegments.

Das erste Hochspannungssegment 6a kann weiterhin eine zum Gate des Bipolartransistors T1 antiparallel geschaltete Diode D5 aufweisen. Darüber hinaus kann eine Schutzschaltung bestehend aus einer Parallelschaltung einer Suppressordiode D6 und eines Varistors VDR1 zwischen Kollektor und Emitter des Bipolartransisitors T1 vorgesehen sein. Zur Erhöhung des Nennstroms kann weiterhin wenigstens ein weiterer Bipolartransisitor T1a parallel zum Bipolartransistor T1 geschalten sein. Die zwischen dem oberen und unteren Anschluss des Hochspannungssegments 6a abfallende Spannung sei als U1 vereinbart.

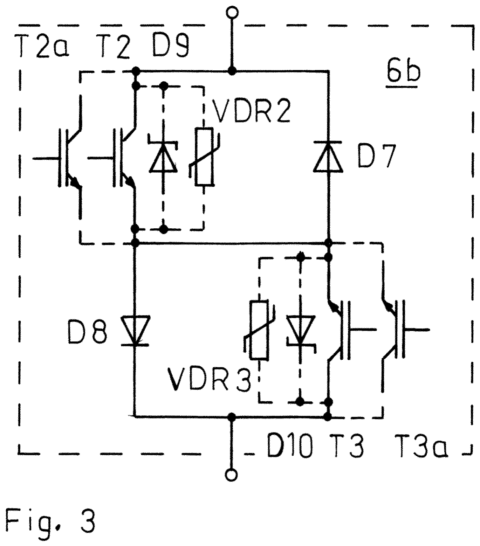

Die Fig. 3 zeigt ein kaskadierbares Hochspannungsschaltsegment 6b mit Dioden D und Bipolartransistoren T mit isolierter Gate-Elektrode zur Nennstromübernahme in einer prinzipiellen Darstellung.

In einer zweiten Ausführungsform bestehen die Brückenzweige eines zweiten Hochspannungssegments 6b aus jeweils einer Reihenschaltung eines Bipolartransistors T2, T3 und einer Diode D7, D8 jeweils zur Nennstromübernahme, wobei in den Brückenzweigen jeweils der Emitter des Bipolartransistors T2, T3 mit der Anode der Diode D7, D8 zusammengeschaltet sind. Die Emitter der Bipolartransistoren T2, T3 und die Anoden der Dioden D7, D8 sind miteinander verbunden. Die zusammengeschalteten Brückenzweige und die Gates der Bipolartransistoren T2, T3 sind die Anschlüsse des zweiten Hochspannungssegments 6b, wobei die Gates der Bipolartransistoren zusammengeschaltete auch ein Anschluss sein können.

Das zweite Hochspannungssegment 6b kann weiterhin zu den Gates der Bipolartransistoren T2, T3 jeweils eine antiparallel geschaltete Diode D9, D10 aufweisen. Darüber hinaus können Schutzschaltungen bestehend jeweils aus einer Parallelschaltung einer Suppressordiode D9, D10 und eines Varistors VDR2, VDR3 zwischen Kollektor und Emitter des jeweiligen Bipolartransisitors T2, T3 vorgesehen sein. Zur Erhöhung des Nennstroms können die Bipolartransistoren T2, T3 jeweils wenigstens einen parallel dazu geschalteten weiteren Bipolartransisitor T2a, T3a aufweisen. Die zwischen dem oberen und unteren Anschluss des Hochspannungssegments 6b abfallende Spannung sei als U1 vereinbart.

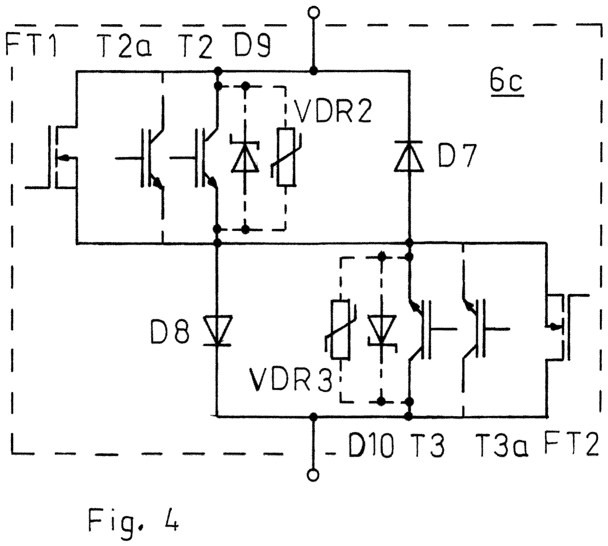

Die Fig. 4 zeigt ein kaskadierbares Hochspannungsschaltsegment 6c mit Dioden D, Bipolartransisitoren T mit isolierter Gate-Elektrode und Feldeffekttransistoren FT in einer prinzipiellen Darstellung.

In einer dritten Ausführungsform sind parallel zu den Bipolartransistoren T2, T3 der zweiten Ausführungsform jeweils ein Feldeffekttransistor FT1, FT2 geschalten, wobei jeweils der Emitter des Bipolartransistors T2, T3 mit der Source-Elektrode des Feldeffekttransistors FT1, FT2 und der Kollektor des Bipolartransistors T2, T3 mit der Drain-Elektrode des Feldeffekttransistors FT1, FT2 verbunden sind. Die zusammengeschalteten Brückenzweige sind die Anschlüsse des Hochspannungsschaltsegments 6c zur Kaskadierung. Die Gate-Elektroden der Bipolartransistoren T2, T3 und der Feldeffekttransistoren FT sind mit der Gate-Ansteuerung verbunden. Als Feldeffekttransistoren FT werden insbesondere MOSFET's verwendet.

Ein kaskadierbares Hochspannungsschaltsegment 6a der ersten Ausführungsform kann auch mit Feldeffekttransistoren FT versehen werden. Dabei sind Feldeffekttransistoren FT parallel zu dem Bipolartransisitor T1 und jeweils zu den Dioden D1, D2, D3, D4 zu schalten.

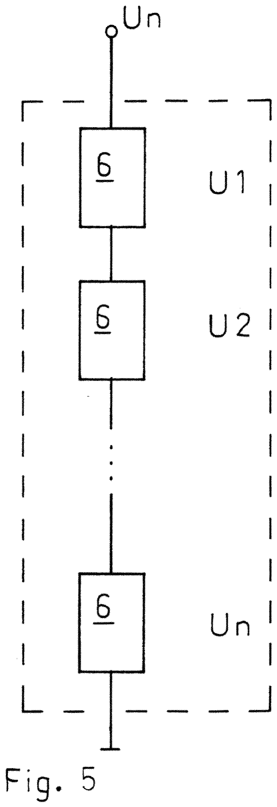

Die Fig. 5 zeigt eine Reihenschaltung von Hochspannungsschaltsegmenten 6 in einer prinzipiellen Darstellung.

Erste Hochspannungsschaltsegmente 6a oder zweite Hochspannungsschaltsegmente 6b sind zur Erzielung höherer Nennspannungen in Reihe geschaltet. Die gesamte Nennspannung ergibt sich durch Summierung der Einzelnennspannungen der jeweiligen Hochspannungsschaltsegmente 6a, 6b.

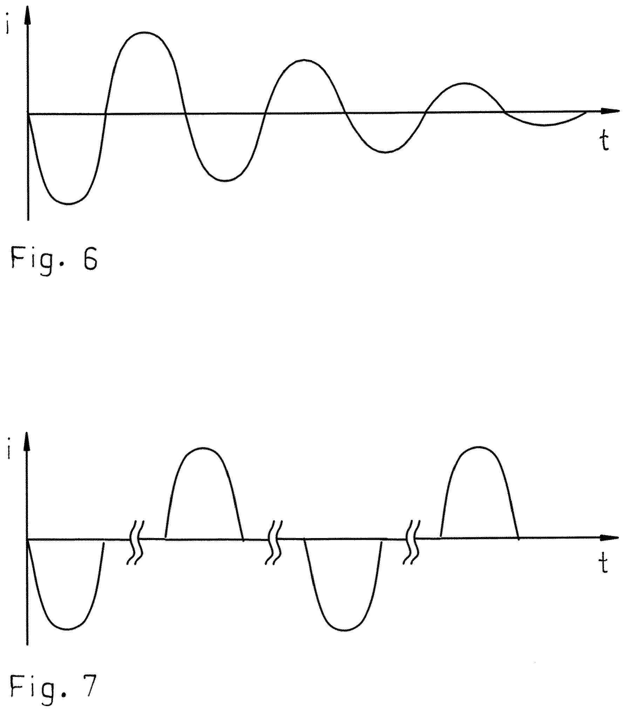

Die Fig. 6 zeigt ein mittels eines Hochspannungsschaltsegments 6 hervorgerufenen DAC-Laststromfluss in einer prinzipiellen Darstellung.

Bei dem ersten Hochspannungsschaltsegment 6a wird oder werden nach der Verbindung und nachfolgenden Trennung der Verbindung der Hochspannungsquelle 1 und des Schutzwiderstands R durch die Schalteinrichtung 2 zu Beginn der Erzeugung einer gedämpften Wechselspannung (DAC-Spannung - Damped AC) das Gate des Bipolartransistors T1 oder die Gates der Bipolartransistoren T1, T1a für die Gesamtdauer des DAC-Vorgangs eingeschaltet. Gemäß der Spannungspolarität fließt der DAC-Laststrom über die Bauelemente D1, T1, D4 oder D3, T1, D2. Bei parallel geschalteten Bipolartransistoren T1, T1 a natürlich über diese beiden.

Bei dem zweiten Hochspannungsschaltsegment 6b werden nach der Verbindung und nachfolgenden Trennung der Verbindung der Hochspannungsquelle 1 und des Schutzwiderstands R durch die Schalteinrichtung 2 zu Beginn der Erzeugung einer gedämpften Wechselspannung (DAC-Spannung - Damped AC) die Gates der Bipolartransistoren T2, T3 oder T2, T2a, T3, T3a für die Gesamtdauer des Vorgangs eingeschaltet. Gemäß der Spannungspolarität fließt der Laststrom über die Bauelemente T2, D8 oder D7, T3. Bei parallel geschalteten Bipolartransistoren T2, T2a und T3, T3a natürlich jeweils über diese beiden.

Das gilt natürlich auch für in Reihe geschaltete erste Hochspannungsschaltsegmente 6a oder für in Reihe geschaltete zweite Hochspannungsschaltsegmente 6b, wobei höhere Nennspannungen erzielt werden.

Die Fig. 7 zeigt einen mittels eines Hochspannungsschaltsegments 6 im VLF-Betrieb hervorgerufenen Laststromfluss in einer prinzipiellen Darstellung.

Bei dem ersten Hochspannungsschaltsegment 6a wird oder werden nach der Verbindung und nachfolgenden Trennung der Verbindung der Hochspannungsquelle 1 und des Schutzwiderstands R1 durch die Schalteinrichtung 2 für den Start des Umschwingvorgangs der Bipolartransisitor T1 oder die Bipolartransistoren T1, T1a über das Gate eingeschaltet. Nach dem Polaritätswechsel der Spannung (Umschwingen) wird im Stromnulldurchgang (Erkennung durch Stromnulldurchgangserkennung) das Gate oder die Gates abgeschaltet. Danach beginnt die Nachladephase Gleichspannung durch die Verbindung zur Hochspannungsquelle 1 mittels der Schalteinrichtung 2. Ist diese beendet, wird oder werden erneut der Bipolartransistor T1 oder die Bipolartransistoren T1, T1a per Gate eingeschaltet und es wird mit entgegengesetzter Stromrichtung umgeschwungen. Die Einzelvorgänge werden entsprechend der gewünschten VLF-Prüfzeit beliebig wiederholt. Gemäß der Spannungspolarität fließt der entsprechende VLF-Laststrom (Umschwingstrom iu) über die Bauelemente D1, T1 (T1, T1 a), D4 oder D3, T1 (T1, T1 a) D2. Die VLF-Spannung am Kabel 4 hat während des Umschwingens einen cosinusförmigen Verlauf.

Bei dem zweiten Hochspannungsschaltsegment 6b wird nach der Verbindung und nachfolgenden Trennung der Verbindung der Hochspannungsquelle 1 und des Schutzwiderstands R durch die Schalteinrichtung 2 für den Start des Umschwingvorgangs der Bipolartransisitor T3 (T3, T3a) über das Gate eingeschaltet. Der Polaritätswechsel der Spannung (Umschwingen) am Kabel 4 wird selbstständig durch das Abschalten der Diode D7 beendet. Danach beginnt die Spannungsnachladephase durch die Verbindung zur Hochspannungsquelle 1 mittels der Schalteinrichtung 2. Ist diese beendet, wird der Bipolartransistor T2 (T2, T2a) per Gate eingeschaltet und mit entgegengesetzter Stromrichtung umgeschwungen. Der Polaritätswechsel wird durch Abschalten der Diode D8 beendet. Die Einzelvorgänge werden entsprechend der gewünschten VLF-Prüfzeit beliebig wiederholt. Gemäß der Spannungspolarität fließt der entsprechende Laststrom (Umschwingstrom iu) über die Bauelemente T2 (T2, T2a), D8 oder D7, T3 (T3, T3a). Ob der VLF-Betrieb mit T2 (T2, T2a) oder mit T3 (T3, T3a) gestartet wird, ist von der Ladespannungspolarität abhängig.

Das gilt natürlich auch für in Reihe geschaltete erste Hochspannungsschaltsegmente 6a, für in Reihe geschaltete zweite Hochspannungsschaltsegmente 6b oder für in Reihe geschaltete dritte Hochspannungsschaltsegmente 6c, wobei höhere Nennspannungen erzielt werden.

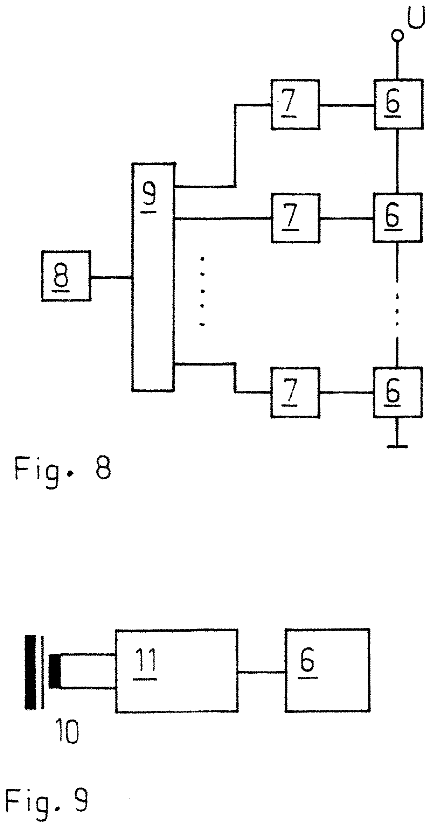

Die Fig. 8 zeigt ein Blockschaltbild mit einer Gate-Ansteuerung mittels elektromagnetischer Strahlung in einer prinzipiellen Darstellung.

Zur Ansteuerung der Bipolartransistoren T der Hochspannungsschaltsegmente 6 können die Gates der Bipolartransistoren T über Empfänger 7 für elektromagnetische Strahlung mit einem Sender 8 für elektromagnetische Strahlung verbunden sein. Elektromagnetische Strahlung kann dazu Licht insbesondere eines Lasers sein. Die Verbindungen sind dabei Lichtwellenleiter. Der Ausgang des Senders 8 kann mit einem Mischer/Verteiler 9 und dieser mit den Empfängern 7 verbunden sein. Der Mischer/Verteiler 9 ist dazu beispielsweise ein Hohlkörper mit dem Eingang für die elektromagnetische Strahlung und mehreren Ausgängen in Verbindung mit den Gates der Bipolartransistoren T der Hochspannungsschaltsegmente 6. Im Hohlkörper können sich strahlführende und/oder strahlbeeinflussende Elemente befinden. Mit diesem Mischer/Verteiler 9 ist gewährleistet, dass die Gates aller Bipolartransistoren T der Hochspannungsschaltsegmente 6 gleichzeitig angesteuert werden und damit Schalten.

Die Fig. 9 zeigt eine Gate-Ansteuerschaltung mit einem Ringkernübertrager 10 in einer prinzipiellen Darstellung.

Zur Ansteuerung der Bipolartransistoren T der Hochspannungsschaltsegmente 6 kann auch ein Ringkernübertrager 10 als Übertrager verwendet werden. Dazu sind die Gates der Bipolartransistoren T jeweils über einen Treiber 11 mit dem mehrere Windungen aufweisenden Spule als Sekundärseite des Ringkernübertragers 10 verbunden. Die Primärseite des Ringkernübertragers 10 kann eine Windung einer hochisolierenden Leitung sein.

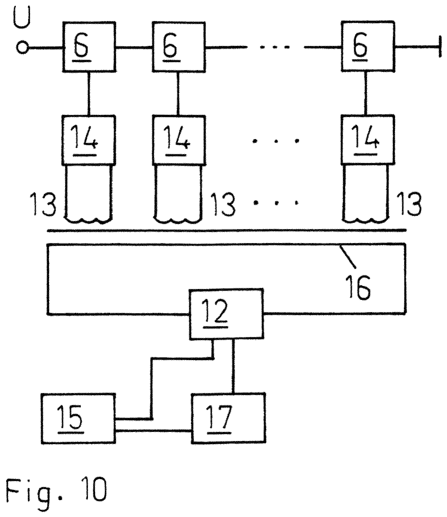

Die Fig. 10 zeigt eine Gate-Ansteuerschaltung mit einem Impulsübertrager 12 in einer prinzipiellen Darstellung.

Ein Bereich der Primärseite des Übertragers mit einer Windung einer hochisolierenden Leitung kann auch eine langgestreckte Leitung 16 sein und dabei gerade verlaufen, so dass die Spulen 13 als Sekundärseiten des Übertragers und die nachgeschalteten Treiber 14 in gerader Reihe auf einem Bauelementeträger anordenbar sind. Die hochisolierende Leitung ist als Bestandteil des Impulsübertragers 12 über eine Steuerung 17 mit einer Stromversorgung 15 verbunden.

Die aufgeführten Ansteuerungen der Bipolartransistoren T können natürlich auch zur Ansteuerung der Feldeffekttransistoren FT der dritten Hochspannungsschaltsegmente 6c verwendet werden, wobei die Gates der Bipolartransisitoren T und die Gates der Feldeffekttransistoren FT miteinander und mit der jeweiligen Gate-Ansteuerung oder Gate-Ansteuerschaltung verbunden.

### Bezugszeichenliste

- 1: Hochspannungsquelle
- 2: Schalteinrichtung
- 3: Umschwingschalteranordnung
- 4: Kabel
- 5: Schutzglied
- 6: Hochspannungsschaltsegment
- 7: Empfänger
- 8: Sender
- 9: Mischer/Verteiler
- 10: Ringkernübertrager
- 11: Treibermodul
- 12: Impulsübertrager
- 13: Spule
- 14: Treiber
- 15: Stromversorgung
- 16: langgestreckte Leitung
- 17: Steuerung
- L: Umschwingdrossel
- R: Schutzwiderstand
- C: Stützkondensator
- D: Diode
- VDR: Varistor
- T: Bipolartransistor
- FT: MOSFET

## Patentansprüche

1. Hochspannungsschaltungsanordnung zur Diagnose und Prüfung von Betriebsmitteln der elektrischen Energietechnik mit
- wenigstens einer ein Bezugspotential und ein Spannungspotential aufweisenden Hochspannungsquelle (1),
- einer mit dem Spannungspotential der Hochspannungsquelle (1) verbundenen Schalteinrichtung (2) in Verbindung mit einer Reihenschaltung aus einem Schutzwiderstand (R) und einer Umschwingdrossel (L),
- dem mit der Umschwingdrossel (L) und dem Bezugspotential zusammengeschalteten Betriebsmittel und
- einer Umschwingschalteranordnung (3) zwischen der Verbindung des Schutzwiderstands (R) mit der Umschwingdrossel (L) und dem Bezugspotential,
**dadurch gekennzeichnet, dass** die Umschwingschalteranordnung (3) aus einer in Reihe geschalteten Kaskade von Hochspannungsschaltsegmenten (6) besteht, dass das Hochspannungsschaltsegment (6) zur Kommutierung zwei Brückenzweige mit Dioden (D) zur Nennstromübernahme und wenigstens einen Bipolartransistor (T) mit isolierter Gate-Elektrode zur Nennstromübernahme aufweist und dass die Gate-Elektroden der Bipolartransistoren (T) der Hochspannungsschaltsegmente (6) mit einer Gate-Ansteuerung verbunden sind.

2. Hochspannungsschaltungsanordnung nach Patentanspruch 1, **dadurch gekennzeichnet, dass** die Brückenzweige des Hochspannungsschaltsegments (6) aus jeweils zwei in Reihe geschalteter Dioden (D) zur Nennstromübernahme bestehen, wobei in einem ersten Brückenzweig die Katoden der Dioden (D) und im anderen zweiten Brückenzweig die Anoden der Dioden (D) miteinander verbunden sind, dass die zusammengeschalteten Katoden der Dioden (D) des ersten Brückenzweigs mit dem Kollektor des Bipolartransistors (T) und die zusammengeschalteten Anoden der Dioden (D) des zweiten Brückenzweigs mit dem Emitter des Bipolartransisitors (T) verbunden sind und dass die zusammengeschalteten Brückenzweige und die Gate-Elektrode des Bipolartransistors (T) die Anschlüsse des Hochspannungsschaltsegments (6) sind.

3. Hochspannungsschaltungsanordnung nach Patentanspruch 1, **dadurch gekennzeichnet, dass** die Brückenzweige des Hochspannungsschaltsegments (6) aus jeweils einer Reihenschaltung eines Bipolartransistors (T) und einer Diode (D) jeweils zur Nennstromübernahme bestehen, wobei in den Brückenzweigen jeweils der Emitter des Bipolartransistors (T) mit der Anode der Diode (D) zusammengeschaltet sind, dass die Emitter der Bipolartransistoren (T) und die Anoden der Dioden (D) miteinander verbunden sind und dass die zusammengeschalteten Brückenzweige und die Gate-Elektroden oder die zusammengeschalteten Gate-Elektroden der Bipolartransistoren (T) die Anschlüsse des Hochspannungsschaltsegments (6) sind.

4. Hochspannungsschaltungsanordnung nach den Patentansprüchen 1 und 3, **dadurch gekennzeichnet, dass** parallel zu den Bipolartransistoren (T) jeweils ein Feldeffekttransistor (FT) geschalten sind, wobei jeweils der Emitter des Bipolartransistors (T) mit der Source-Elektrode des Feldeffekttransistors (FT) und der Kollektor des Bipolartransistors (T) mit der Drain-Elektrode des Feldeffekttransistors (FT) verbunden sind, dass die zusammengeschalteten Brückenzweige die Anschlüsse des Hochspannungsschaltsegments (6) zur Kaskadierung sind, und dass die Gate-Elektroden der Bipolartransistoren (T) und der Feldeffekttransistoren (FT) mit der Gate-Ansteuerung verbunden sind.

5. Hochspannungsschaltungsanordnung nach Patentanspruch 2, 3 oder 4, **dadurch gekennzeichnet, dass** zum Kollektor und zum Emitter des Bipolartransisitors (T) eine antiparallel geschaltete Diode (D) vorhanden ist.

6. Hochspannungsschaltungsanordnung nach Patentanspruch 2, 3 oder 4, **dadurch gekennzeichnet, dass** eine Schutzschaltung des Bipolartransistors (T) mit dem Kollektor und dem Emitter des Bipolartransistors (T) verbunden ist.

7. Hochspannungsschaltungsanordnung nach Patentanspruch 2, 3 oder 4, **dadurch gekennzeichnet, dass** zur Erhöhung des Nennstroms die Kollektoren und die Emitter von wenigstens zwei Bipolartransistoren (T) miteinander verbunden sind.

8. Hochspannungsschaltungsanordnung nach Patentanspruch 1, **dadurch gekennzeichnet, dass** die Gate-Ansteuerung wenigstens einen Empfänger für elektromagnetische Strahlung in Verbindung mit den Gates der Bipolartransistoren (T), den Gates von Bipolartransistoren (T) oder jeweils einem Gate eines Bipolartransisitors (T) aufweist und dass der Empfänger oder die Empfänger für elektromagnetische Strahlung mit einem das Einschaltsignal oder das Ausschaltsignal erzeugenden Sender für elektromagnetische Strahlung verbunden ist oder sind.

9. Hochspannungsschaltungsanordnung nach Patentanspruch 1, **dadurch gekennzeichnet, dass** die Gate-Ansteuerung Treiber (14) in Verbindung mit jeweils einem Gate des Bipolartransisitors (T) sind, dass jeder der Treiber (14) mit einer mehrere Windungen aufweisenden Spule (13) als Sekundärseite eines Ringkernübertragers 10 verbunden ist und dass die Primärseite des Ringkernübertragers (10) eine Windung einer hochisolierenden Leitung ist.

10. Hochspannungsschaltungsanordnung nach Patentanspruch 9, **dadurch gekennzeichnet, dass** die hochisolierende Leitung der Kern der Spulen (13) als Primärseite des Ringkernübertragers (10) ist.

11. Hochspannungsschaltungsanordnung nach Patentanspruch 1, **dadurch gekennzeichnet, dass** die Hochspannungsschaltungsanordnung eine Hochspannungsschaltungsanordnung zur Prüfung und Diagnose eines Kabels (4) als Betriebsmittel ist, wobei die Schalteinrichtung (2) zur Prüfung und Diagnose des Kabels (4) eine Verbindung zwischen Hochspannungsquelle (1) und Schutzwiderstand (R) herstellt und trennt, so dass sich eine gedämpfte Wechselspannung durch die Umschwingschalteranordnung (3), die Umschwingdrossel (L) und das Kabel (4) ausbildet.

12. Hochspannungsschaltungsanordnung nach Patentanspruch 1, **dadurch gekennzeichnet, dass** die Hochspannungsschaltungsanordnung eine Hochspannungsschaltungsanordnung zur Prüfung und Diagnose eines Betriebsmittels mit einer VLF (very low frequency) cosinusförmigen Spannung als eine Halbschwingung ist, wobei nach einem verbindenden und trennenden Schaltvorgang der Schalteinrichtung (2) eine Aufladung des Betriebsmittels erfolgt, die cosinusförmige Halbschwingung durch die Umschwingschalteranordnung (3) in Verbindung mit der Umschwingdrossel (L) und dem Betriebsmittel generiert wird und durch einen Schaltvorgang eine Nachladung des Betriebsmittels erfolgt.

13. Hochspannungsschaltungsanordnung nach Patentanspruch 1, **dadurch gekennzeichnet, dass** die Hochspannungsschaltungsanordnung eine erste Hochspannungsquelle mit einer gegenüber dem Bezugspotential negativen Spannung an deren Ausgang und eine zweite Hochspannungsquelle mit einer gegenüber dem Bezugspotential positiven Spannung an deren Ausgang aufweist und dass die Ausgänge über eine Schalteinrichtung (2) mit dem Schutzwiderstand (R) verbunden sind, so dass am Schutzwiderstand (R) gegenüber dem Bezugspotential die negative oder die positive Spannung der jeweiligen Hochspannungsquelle anliegt und zur Prüfung und Diagnose eines Betriebsmittels eine VLF (very low frequency) cosinusförmige Wechselspannung erzeugt wird.
